# EUROPEAN PATENT APPLICATION

(11) **EP 4 779 859 A1**
(43) Date of publication of application: **22.07.2026**
(21) Application number: 26158249.8
(22) Date of filing: 12.02.2026
(51) Int. Cl.: H02P 1/04, H02P 1/28, H01H 9/56, H02H 7/08, H02H 7/085, H02P 29/024

(54) **METHOD, APPARATUS AND COMPUTER PROGRAM FOR REDUCED-VOLTAGE STARTING OF MOTOR**

(30) Priority: 10.01.2025 CN 202510041559
(71) Applicant: SCHNEIDER ELECTRIC INDUSTRIES SAS, 92500 Rueil-Malmaison (FR)
(72) Inventor: BAI, Wanlong, Shanghai, 201203 (CN); HUANG, Jie, Shanghai, 201203 (CN); BI, Baoyun, Shanghai, 201203 (CN); SHUANG, Bing, Shanghai, 201203 (CN); SHI, Ying, Shanghai, 201203 (CN); YING, Xiaoping, Shanghai, 201203 (CN)
(74) Representative: Openshaw & Co.

(57) **Abstract**

Embodiments of the disclosure provide a method, an apparatus, a storage medium and a program product for reduced-voltage starting of a motor. The method includes: determining (510) a line voltage between a first phase and a second phase in a line in response to obtaining a starting instruction indicating starting of the motor; determining(520) a zero-crossing point of the line voltage; starting(530) a first timing in response to reaching the zero-crossing point of the line voltage; closing(540) a first switch of the first phase and a second switch of the second phase in response to the first timing satisfying a first predetermined duration; starting(550) a second timing in response to the first switch and the second switch being closed; and closing(560) a third switch of a third phase relative to the first phase and the second phase in the line in response to the second timing satisfying a second predetermined duration.

## Description

### FIELD

Example embodiments of the present disclosure generally relate to the field of electrical equipment, and in particular, to a method, an apparatus, a storage medium, and a computer program or computer program product for reduced-voltage starting of a motor.

### BACKGROUND

A semiconductor switch is an electronic switching device made by using properties of semiconductor materials, such as a metal-oxide-semiconductor field-effect transistor (MOSFET) switch. It has the advantages of easy control and fast response, and is widely applied to electric equipment in various fields.

However, a semiconductor device has a short short-circuit withstand time, and an excessive high current peak during the starting of some electrical appliances may erroneously trigger short-circuit protection.

### SUMMARY

In a first aspect of the present disclosure, a method for reduced-voltage starting of a motor is provided. The method includes: determining a line voltage between a first phase and a second phase in a line in response to obtaining a starting instruction indicating starting of the motor; determining a zero-crossing point of the line voltage; starting a first timing in response to reaching the zero-crossing point of the line voltage; closing a first switch of the first phase and a second switch of the second phase in response to the first timing satisfying a first predetermined duration, the first predetermined duration being determined based on at least the zero-crossing point of the line voltage and closing angle information of the motor; starting a second timing in response to the first switch and the second switch being closed; and closing a third switch of a third phase relative to the first phase and the second phase in the line in response to the second timing satisfying a second predetermined duration.

In some embodiments, the method further includes: disconnecting three-phase power supply of the line in response to obtaining an abnormal signal indicating an abnormality of the line; and initializing the first timing and/or the second timing.

In some embodiments, the method further includes: obtaining voltage information across the first switch, the second switch and the third switch respectively in response to the third switch being closed; and disconnecting the three-phase power supply of the line in response to the voltage information across the first switch, the second switch, and the third switch exceeding a predetermined threshold.

In some embodiments, the method further includes: issuing early warning information in response to the three-phase power supply of the line being disconnected.

In some embodiments, the method further includes: determining the first predetermined duration, including: obtaining the closing angle information of the motor; determining a closing time associated with the closing angle information based on the closing angle information and a power supply frequency; and determining the first predetermined duration based on the closing time and the zero-crossing point of the line voltage.

In some embodiments, obtaining the closing angle information of the motor includes: obtaining a power factor of the motor; and determining the closing angle information of the motor based on the power factor of the motor.

In some embodiments, the second predetermined duration is determined based on a characteristic parameter of the motor.

According to the method for reduced-voltage starting of the motor, the first switch and the second switch are closed at an optimal closing angle position of the line voltage between the first phase and the second phase to conduct the first phase and the second phase of the line. The third switch is then closed after the second predetermined duration to conduct the third phase of the line. In this way, the peak value of the first current peak during starting of the motor can be reduced, thereby reducing false triggering of the circuit breaker and prolonging the service life of the semiconductor switch.

In a second aspect of the present disclosure, an apparatus for reduced-voltage starting of a motor is provided. The apparatus includes: a task module configured to obtain a starting instruction indicating starting of the motor; a data processing module configured to determine a line voltage between a first phase and a second phase in a line based on the starting instruction; and determine a zero-crossing point of the line voltage; a control module configured to: start a first timing at the zero-crossing point of the line voltage; close a first switch of the first phase and a second switch of the second phase in response to the first timing satisfying a first predetermined duration, the first predetermined duration being determined based on the zero-crossing point of the line voltage and closing angle information of the motor; start a second timing in response to the first switch and the second switch being closed; and close a third switch of a third phase relative to the first phase and the second phase in the line in response to the second timing satisfying a second predetermined duration.

In some embodiments, the task module is further configured to: disconnect three-phase power supply of the line in response to obtaining an abnormal signal indicating an abnormality of the line; and initialize the first timing and/or the second timing.

In some embodiments, the task module is further configured to: obtain voltage information across the first switch, the second switch and the third switch respectively in response to the third switch being closed; and disconnect three-phase power supply of the line in response to the voltage information across the first switch, the second switch, and the third switch respectively exceeding a predetermined threshold.

In some embodiments, the task module is further configured to issue early warning information in response to the three-phase power supply of the line being disconnected.

In some embodiments, the data processing module is further configured to determine a first predetermined duration, including: obtaining closing angle information of the motor; determining a closing time associated with the closing angle information based on the closing angle information and a power supply frequency; and determining a first predetermined duration based on the closing time and the zero-crossing point of the line voltage.

In some embodiments, obtaining the closing angle information of the motor includes: obtaining a power factor of the motor; and determining the closing angle information of the motor based on the power factor of the motor.

In some embodiments, the second predetermined duration is determined based on a characteristic parameter of the motor.

In some embodiments, a latency of the data processing module is lower than a latency of the task module; and a latency of the control module is lower than the latency of the data processing module.

In a third aspect of the present disclosure, an electronic device is provided. The device includes at least one processing unit; and at least one memory coupled to the at least one processing unit and storing instructions for execution by the at least one processing unit. The instructions, when executed by the at least one processing unit, cause the device to implement the method of the first aspect.

In a fourth aspect of the present disclosure, a computer-readable storage medium is provided. The computer-readable storage medium stores a computer program, and the computer program is executed by the processor to implement the method of the first aspect.

It should be understood that the content described in this content section is not intended to limit the key features or important features of embodiments of the present disclosure, nor is it intended to limit the scope of the present disclosure. Other features of the present disclosure will become readily understood from the following description.

### BRIEF DESCRIPTION OF DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements, wherein:
FIG. 1 illustrates a simplified circuit diagram of a switching apparatus for a motor according to some embodiments of the present disclosure;
FIG. 2 illustrates a schematic diagram of an apparatus for reduced-voltage starting of a motor according to some embodiments of the present disclosure;
FIG. 3 illustrates a flowchart of a reduced-voltage starting process of a motor according to some embodiments of the present disclosure;
FIG. 4 illustrates a schematic diagram of a communication interaction of an apparatus during starting of a motor according to some embodiments of the present disclosure;
FIG. 5 illustrates a schematic block diagram of a method for reduced-voltage starting of a motor according to some embodiments of the present disclosure; and
FIG. 6 illustrates a schematic block diagram of an electronic device adapted to implement embodiments of the present disclosure.

### DETAILED DESCRIPTION

Embodiments of the present disclosure will be described in more detail below with reference to the accompanying drawings. While certain embodiments of the present disclosure are shown in the accompanying drawings, it should be understood that the present disclosure may be implemented in various forms, and should not be construed as limited to embodiments set forth herein, but rather, these embodiments are provided for a more thorough and complete understanding of the present disclosure. It should be understood that the drawings and embodiments of the present disclosure are for illustrative purposes only and are not intended to limit the scope of the present disclosure.

It should be noted that the title of any section/subsection provided herein is not limiting. Various embodiments are described throughout and any type of embodiments may be included in any section/subsection. Furthermore, embodiments described in any section/subsection may be combined in any manner with the same section/subsection and/or any other embodiment described in different sections/subsections.

In the description of embodiments of the present disclosure, the terms "including" and the like should be understood to include "including but not limited to". The term "based on" should be understood as "based at least in part on". The terms "one embodiment" or "the embodiment" should be understood as "at least one embodiment". The term "some embodiments" should be understood as "at least some embodiments". Other explicit and implicit definitions may also be included below. The terms "first," "second," and the like may refer to different or identical objects. Other explicit and implicit definitions may also be included below.

As mentioned briefly above, due to the short short-circuit withstand time of the semiconductor device, the excessively high first current peak during the starting of some electrical appliances (for example, a high-efficiency motor) may erroneously trigger a short-circuit condition, so that the electrical appliance cannot be normally started.

The present disclosure provides a solution for reduced-voltage starting of a motor to solve or to at least partially solve the above problems and other potential problems existing in the conventional solutions. A method for reduced-voltage starting of a motor according to some embodiments of the present disclosure includes determining a line voltage between a first phase and a second phase in a line in response to obtaining a starting instruction indicating starting of the motor; determining a zero-crossing point of the line voltage; starting a first timing in response to reaching the zero-crossing point of the line voltage; closing a first switch of the first phase and a second switch of the second phase in response to the first timing satisfying a first predetermined duration, the first predetermined duration being determined based on at least the zero-crossing point of the line voltage and closing angle information of the motor; starting a second timing in response to the first switch and the second switch being closed; and closing a third switch of a third phase relative to the first phase and the second phase in the line in response to the second timing satisfying a second predetermined duration.

The first switch and the second switch are closed at the optimal closing angle position of the line voltage between the first phase and the second phase to conduct the first phase and the second phase of the line. The third switch is then closed after a second predetermined duration to conduct the third phase of the line. In this way, the peak value of the first current peak during the starting of the motor can be reduced, thereby reducing false triggering of the circuit breaker and prolonging the service life of the semiconductor switch.

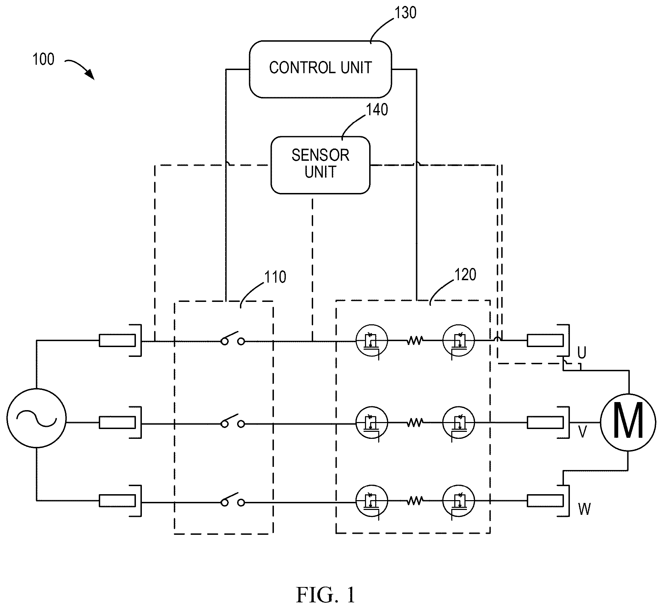

FIG. 1 shows a simplified circuit diagram of a switching apparatus 100 for a motor according to some embodiments of the present disclosure. As shown in FIG. 1, the switching apparatus 100 of the motor generally includes a mechanical switch 110, an electrical switch 120, a control unit 130 coupled to the mechanical switch 110 and the electrical switch 120, and a sensor unit 140. The control unit 130 controls closing or opening of the mechanical switch 110 and/or the electrical switch 120 to conduct or break a power supply line of the motor (hereinafter also referred to as a line). In some embodiments, the electrical switch 120 includes three semiconductor switches respectively coupled to a three-phase power supply of the line. The control module 230 may respectively control the on-off of the three-phase power supply through three semiconductor switches. The sensor unit 140 is disposed between the control unit 130 and the line and is adapted to obtain an electrical signal of the line, such as a voltage signal or a current signal. In some embodiments, the sensor unit 140 may obtain electrical signals at multiple positions on the line. For example, the sensor unit 140 may obtain the voltage signal across the mechanical switch 110, obtain the voltage signal across the electrical switch 120, and obtain the current signal at a power supply end of the motor. The sensor unit 140 is coupled to the control unit 130 and adapted to send the obtained electrical signal of the line to the control unit 130.

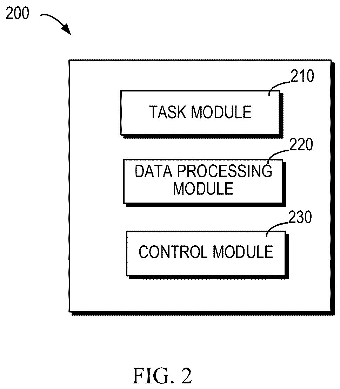

An apparatus for reduced-voltage starting of the motor according to embodiments of the present disclosure is at least partially coupled to or is at least part of the switching apparatus 100. For example, the apparatus for reduced-voltage starting of the motor may be at least part of the control unit 130 of the switching apparatus 100, and the apparatus may also be the control unit 130 coupled to the switching apparatus 100 as a separate component. The apparatus may obtain the electrical signal of the line through the control unit 130, and control the breaking of the semiconductor switch in the line. FIG. 2 shows a schematic diagram of an apparatus 200 for reduced-voltage starting of a motor according to some embodiments of the present disclosure. As shown in FIG. 2, the apparatus 200 generally includes a task module 210, a data processing module 220, and a control module 230. The task module 210 is adapted to obtain a starting instruction issued by a user indicating starting of the motor. The data processing module 220 is adapted to determine a line voltage between a first phase and a second phase in a line according to the electrical signal in the line, and determine a zero-crossing point of the line voltage and a closing timing of the first phase and the second phase based on the line voltage. The control module 230 is adapted to control three semiconductor switches of the electrical switch to be closed at an appropriate closing timing to achieve the reduced-voltage starting of the motor. That is, an impact current during starting of the motor is reduced, thereby reducing the short-circuit false triggering of the solid-state circuit breaker. The method for reduced-voltage starting of the motor will be described in more detail hereinafter.

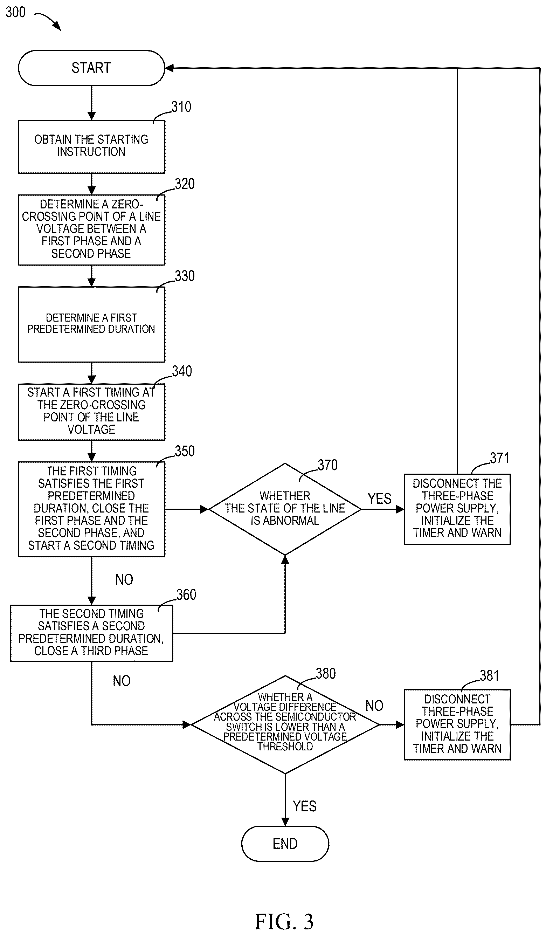

FIG. 3 illustrates a flowchart of a reduced-voltage starting process 300 of a motor according to some embodiments of the present disclosure. In some embodiments, the process 300 shown in FIG. 3 may be implemented by the apparatus 200. As shown in FIG. 3, a user issues a starting instruction indicating starting of the motor to the apparatus 200. At block 310, the apparatus 200 obtains the starting instruction. At block 320, the apparatus 200 determines a zero-crossing point of a line voltage between a first phase and a second phase in a line. At block 330, the apparatus 200 determines a first predetermined duration based on the zero-crossing point of the line voltage and closing angle information of the motor. At block 340, the apparatus 200 starts a timer at the zero-crossing point of the line voltage and performs a first timing associated with the first predetermined duration. At block 350, after the first timing satisfies the first predetermined duration, the apparatus 200 closes the first phase and the second phase of the line, resets the timer, and starts a second timing. At block 360, after the second timing satisfies a second predetermined duration, the apparatus 200 closes a third phase of the line, thereby normally supplying power to the motor.

In some embodiments, the apparatus 200 may further detect an abnormal state in the line. For example, at block 370, the apparatus 200 may detect whether the state of the line is abnormal. For example, during the closing of the three-phase semiconductor switch of the line (i.e., at least one of the first switch of the first phase, the second switch of the second phase, and the third switch of the third phase is closed), the apparatus 200 may detect whether a short-circuit condition or other problem occurs in the line. If the apparatus 200 determines that an abnormality occurs in the line, at block 371, the apparatus 200 disconnects the three-phase power supply of the line (i.e., disconnects the first switch, the second switch, and the third switch), and initializes the timer while issuing a warning indicating the abnormality of the line.

In some embodiments, the apparatus 200 may further detect a voltage condition across the first switch, the second switch, and the third switch after all three phases of the power supply are closed, and at block 380, the apparatus 200 compares the voltage across the semiconductor switch with a predetermined voltage threshold to determine whether the semiconductor switch is closed. If the voltage across the semiconductor switch is higher than the predetermined voltage threshold, then the apparatus 200 disconnects the three phases of the power supply of the line (i.e., disconnects the first switch, the second switch, and the third switch) at block 381, and initializes the timer while issuing a warning indicating an abnormality of the switch.

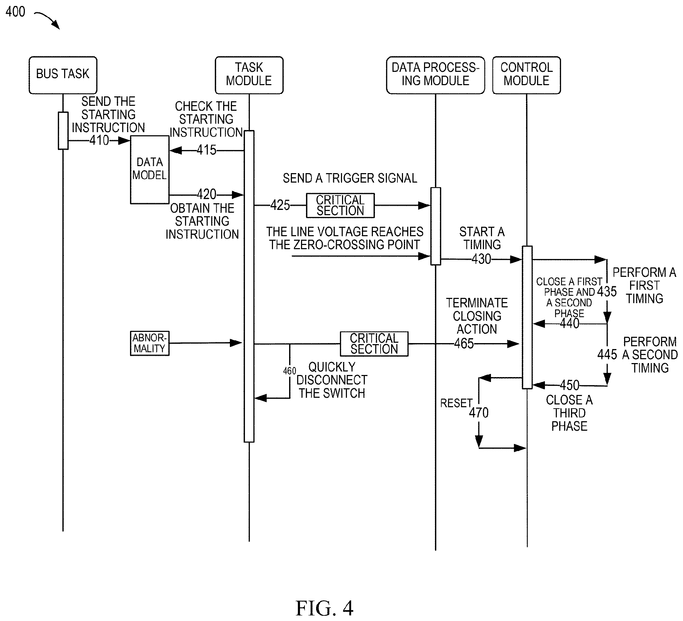

FIG. 4 shows a schematic diagram of a communication interaction 400 of an apparatus 200 during starting of a motor according to some embodiments of the present disclosure. As shown in FIG. 4, after a user issues a starting instruction for starting the motor, a bus task sends (410) the starting instruction to a data model. After checking (415) the starting instruction, a task module 210 obtains (420) the starting instruction from the data model. The task module 210 sends (425) a trigger signal for closing the switch to the data processing module 220 via a message mechanism such as a critical section. The data processing module 220 may start (430) a timing of the control module 230 when a line voltage between a first phase and a second phase reaches a zero-crossing point. The control module 230 performs (435) a first timing and closes (440) a first switch of the first phase and a second switch of the second phase after the first timing satisfies a first predetermined duration. At the same time, the control module 230 performs (445) a second timing. The control module 230 closes (450) a third switch of a third phase after the second timing satisfies a second predetermined duration.

In some embodiments, if the line or the switch is abnormal (e.g., a short-circuit condition occurs in the line or a switch fails to be closed normally), an abnormal signal indicating an abnormality is sent to the task module 210, the task module 210 quickly disconnects (460) the switch, and terminates (465) a closing action of the control module 230 through the message mechanism such as the critical section. After receiving a termination signal indicating the termination of the closing action of the control module 230, the control module 230 resets (470) the timing of the timer.

In some embodiments, a latency of the control module 230 is lower than a latency of the data processing module 220, and the latency of the data processing module 220 is lower than a latency of the task module 210. For example, in some embodiments, a refresh cycle of the control module 230 may be 1ms, a refresh cycle of the data processing module 220 may be 125 µs (that is, the refresh cycle of the data processing module 220 is 8000/s), and the response speed of the action of the control module 230 is the highest, that is, the latency of the control module 230 is lower than 125 µs. In this way, the control accuracy of the apparatus 200 can be improved, and the error between the closing timing of the first switch and the second switch and the optimal closing angle can be reduced. In some embodiments, the closing accuracy of the apparatus 200 for the first switch and the second switch may be controlled within an error range of ± 4 ° of the optimal closing angle.

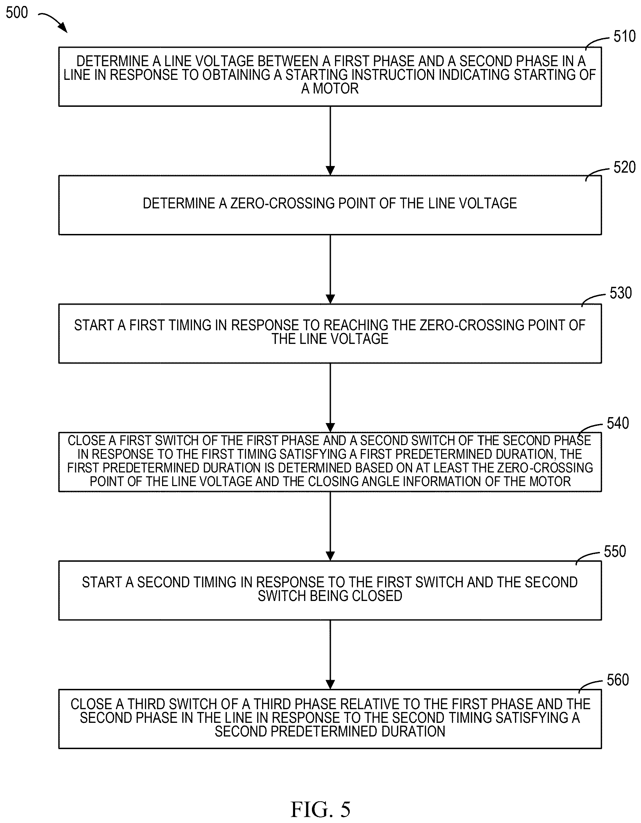

FIG. 5 shows a schematic block diagram of a method 500 for reduced-voltage starting of a motor according to some embodiments of the present disclosure. In some embodiments, the method 500 may be performed by the apparatus 200, and in some more specific embodiments, the method 500 may further be performed by the task module 210, the data processing module 220, and/or the control module 230 integrated in the apparatus 200.

As shown in FIG. 5, at block 510, the apparatus 200 determines a line voltage between a first phase and a second phase in a line in response to obtaining a starting instruction indicating starting of a motor. In some embodiments, the user issues the starting instruction to the apparatus 200, the starting instruction may be issued by the user through a mechanical structure such as a handle and a knob, and in some other embodiments, the starting instruction may further be issued by the user remotely through a wired data connection or a wireless data connection.

In some embodiments, after obtaining the starting instruction, the apparatus 200 collects electrical information of the first phase and the second phase in the line. It should be understood that the first phase and the second phase of embodiments of the present disclosure are understood as any two phases of three-phase (U, V, W) power supply, and a third phase should be understood as one phase different from the first phase and the second phase in the three-phase power supply. The apparatus 200 may determine the line voltage between the first phase and the second phase based on the obtained electrical information of the first phase and the electrical information of the second phase.

At block 520, the apparatus 200 determines a zero-crossing point of the line voltage. At block 530, the apparatus 200 starts a first timing in response to reaching the zero-crossing point of the line voltage. In some embodiments, if the data processing module 220 determines that the line voltage between the first phase and the second phase reaches the zero-crossing point, the control module 230 starts the first timing.

At block 540, the apparatus 200 closes a first switch of the first phase and a second switch of the second phase in response to the first timing satisfying a first predetermined duration, the first predetermined duration is determined based on at least the zero-crossing point of the line voltage and the closing angle information of the motor.

In some embodiments, determining the first predetermined duration includes: the apparatus 200 obtaining the closing angle information of the motor. The apparatus 200 determines a closing time associated with the closing angle information based on the closing angle information and a power supply frequency. The apparatus 200 determines the first predetermined duration based on the closing time and the zero-crossing point of the line voltage.

In some embodiments, obtaining the closing angle information of the motor includes: the apparatus 200 obtaining a power factor of the motor; the apparatus 200 determining the closing angle information of the motor based on the power factor of the motor. Specifically, the apparatus 200 may determine the closing angle information of one motor by using a correspondence table between the power factor and the optimal closing angle. In some embodiments, the power factor of the motor may be manually input by the user to the apparatus 200, and in some other embodiments, the power factor of the motor may also be determined by the apparatus 200 or the control unit 130 according to an operating voltage and an operating current of the motor obtained in real-time.

At block 550, the apparatus 200 starts a second timing in response to the first switch and the second switch being closed. At block 560, the apparatus 200 closes a third switch of a third phase relative to the first phase and the second phase in the line in response to the second timing satisfying a second predetermined duration.

If the control module 230 completes the first timing, the timing of the control module 230 is reset and the second timing is started. The control module 230 closes the third switch of the third phase after the second timing satisfies the second predetermined duration. In some embodiments, the second predetermined duration is determined based on a characteristic parameter of the motor. For example, after the first switch and the second switch are closed, a first-phase coil and a second-phase coil of the motor are energized. The second predetermined duration may be determined to be an appropriate value that does not affect the establishment of the overall magnetic field of the motor, e.g., 5ms.

The apparatus 200 may perform a time-domain conversion on the obtained closing angle information in combination with the current power supply frequency to determine the optimal closing timing (i.e., the closing time). The first predetermined duration associated with the first timing is determined based on the optimal closing timing and zero-crossing point of the line voltage.

In some embodiments, the method 500 further includes: the apparatus 200 disconnecting the three-phase power supply of the line in response to obtaining an abnormal signal indicating an abnormality of the line. The apparatus 200 initializes the first timing and/or the second timing. If the control module 230 is in the timing period (including the first timing and the second timing) and the apparatus determines that an abnormality (e.g., a short-circuit condition occurs in the line ) exists in the line , the apparatus 200 may disconnect the first switch, the second switch, and the third switch (if the third switch is in the off state at this time, no operation is performed on the third switch), and initialize the timing of the control module 230, thereby interrupting the starting operation on the motor. In some embodiments, the apparatus 200 may further issue an early warning to the user to indicate an existing abnormality in the line.

In some embodiments, the method 500 further includes: the apparatus 200 respectively obtaining voltage information across the first switch, the second switch, and the third switch in response to the third switch being closed. The apparatus 200 disconnects three-phase power supply of the line in response to the voltage information across the first switch, the second switch, and the third switch exceeding a predetermined threshold.

A closed state of the first switch, the second switch, and the third switch is determined by detecting a voltage difference across the first switch, the second switch, and the third switch. Taking the first switch as an example, if the voltage difference across the first switch is lower than the predetermined threshold, it means that the first switch is closed. If the voltage difference across the first switch exceeds the predetermined threshold, it means that the first switch is not closed. If the apparatus 200 determines that at least one of the first switch, the second switch, and the third switch is not closed, the apparatus 200 disconnects all switches and initializes the timing of the control module 230, thereby interrupting the starting operation of the motor. In some embodiments, the apparatus 200 may further issue an early warning to the user to indicate an existing abnormality in the line.

Referring back to FIG. 2, in some embodiments, the task module 210 is configured to obtain a starting instruction indicating starting of the motor. The data processing module 220 is configured to: determine a line voltage between a first phase and a second phase in a line based on the starting instruction; and determine a zero-crossing point of the line voltage. The control module 230 is configured to: start a first timing at the zero-crossing point of the line voltage; close a first switch of the first phase and a second switch of the second phase in response to the first timing satisfying a first predetermined duration, the first predetermined duration is determined based on the zero-crossing point of the line voltage and closing angle information of the motor; start a second timing in response to the first switch and the second switch being closed; and close a third switch of a third phase relative to the first phase and the second phase in response to the second timing satisfying a second predetermined duration.

In some embodiments, the task module 210 is further configured to: disconnect three-phase power supply of the line in response to obtaining an abnormal signal indicating an abnormality of the line; and initialize the first timing and/or the second timing.

In some embodiments, the task module 210 is further configured to: obtain voltage information across the first switch, the second switch, and the third switch respectively in response to the third switch being closed ; and disconnect three-phase power supply of the line in response to the voltage information across the first switch, the second switch, and the third switch respectively exceeding a predetermined threshold.

In some embodiments, the task module 210 is further configured to issue early warning information in response to the three-phase power supply of the line being disconnected.

In some embodiments, the data processing module 220 is further configured to determine the first predetermined duration, including: obtaining closing angle information of the motor; determining a closing time associated with the closing angle information based on the closing angle information and a power supply frequency; and determining the first predetermined duration based on the closing time and the zero-crossing point of the line voltage.

Obtaining the closing angle information of the motor includes: obtaining a power factor of the motor; and determining the closing angle information of the motor based on the power factor of the motor.

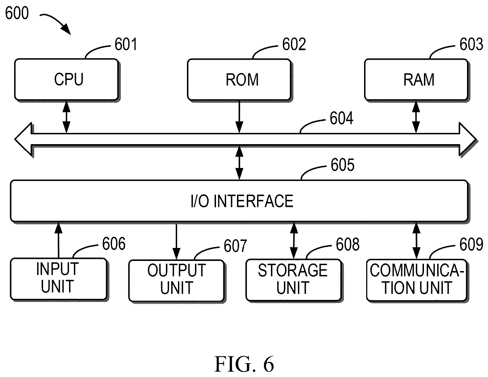

FIG. 6 shows a schematic block diagram of an electronic device adapted to implement embodiments of the present disclosure. As shown in FIG. 6, according to the electronic device provided by the present disclosure, the electronic device 600 may be a circuit breaker or other suitable device for controlling the starting of the motor mentioned above. The electronic device 600 includes a processor, such as a central processing unit (CPU) 601, which may perform various appropriate actions and processes according to computer program instructions stored in a read-only memory (ROM) 602 or computer program instructions loaded into a random access memory (RAM) 603 from a storage unit. In RAM 603, the various programs and data required for the operation of the storage device may also be stored. The CPU 601, the ROM 602, and the RAM 603 are connected to each other through a bus 604. Input/output (I/O) interface 605 is also connected to bus 604.

Multiple components in the device are connected to the I/O interface 605, including: an input unit 606, such as a touch screen, a button, etc. ; an output unit 607, such as various types of displays, speakers, etc. ; a storage unit 608, such as a magnetic disk, an optical disk, etc. ; and a communication unit 609, such as a network card, a modem, a wireless communication transceiver, or the like. The communication unit 609 allows devices to exchange information/data with other devices via computer networks such as the Internet and/or various telecommunication networks.

The various processes described above, such as the method 500 mentioned above, may be performed by the processing unit 601. For example, in some embodiments, the method or process described above may be implemented as a computer software program tangibly included in a machine-readable medium, such as a storage unit. In some embodiments, some or all of the computer program may be loaded and/or installed on the device via ROM 602 and/or communication unit 609. One or more acts of the method or process described above may be performed when the computer program is loaded into the RAM 603 and executed by the CPU 601.

Embodiments of the present disclosure relate to a method, an electronic device, and/or a computer program product. The computer program product may include a computer-readable storage medium having computer-readable program instructions thereon for implementing various aspects of the present disclosure.

The computer-readable storage medium may be a tangible device that may hold and store instructions for use by the instruction execution device. The computer-readable storage medium may be, for example, but is not limited to, an electrical storage device, a magnetic storage device, an optical storage device, an electromagnetic storage device, a semiconductor storage device, or any suitable combination of the foregoing. More specific examples (a non-exhaustive list) of the computer-readable storage medium include: a portable computer disk, a hard disk, a random access memory (RAM), a read-only memory (ROM), an erasable programmable read-only memory (EPROM or Flash memory), a static random access memory (SRAM), a portable compact disk read-only memory (CD-ROM), a digital versatile disk (DVD), a memory stick, a floppy disk, a mechanical encoding device, a punch card or an in-groove raised structure having instructions stored thereon, and any suitable combination thereof. Computer readable storage media used herein is not to be construed as a transitory signal itself, such as radio waves or other free-propagating electromagnetic waves, electromagnetic waves propagating through a waveguide or other transmission medium (e.g., light pulses through a fiber optic cable), or electrical signals transmitted through wires.

The computer-readable program instructions described herein may be downloaded from a computer-readable storage medium to various computing/processing devices, or downloaded to an external computer or external storage device via a network, such as the Internet, a local area network, a wide area network, and/or a wireless network. The network may include a copper transmission cable, an optical fiber transmission, a wireless transmission, a router, a firewall, a switch, a gateway computer, and/or an edge server. The network interface card or network interface in each computing/processing device receives computer readable program instructions from the network and forwards the computer readable program instructions for storage in a computer readable storage medium in each computing/processing device.

Computer program instructions for carrying out the operations of the present disclosure may be assembly instructions, instruction set architecture (ISA) instructions, machine instructions, machine dependent instructions, microcode, firmware instructions, state setting data, or source code or object code written in any combination of one or more programming languages, including an object oriented programming language such as Smalltalk, C + +, etc. , and conventional procedural programming languages, such as the "C" language or similar programming languages. The computer-readable program instructions may execute entirely on a user computer, partially on a user computer, as a stand-alone software package, partially on a user computer, partially on a remote computer, or entirely on a remote computer or server. In the case of a remote computer, the remote computer may be connected to the user computer through any kind of network, including a local area network (LAN) or a wide area network (WAN), or may be connected to an external computer (e.g., connected through the Internet using an Internet service provider). In some embodiments, various aspects of the present disclosure may be implemented by personalizing a custom electronic circuit, such as a programmable logic circuit, a field programmable gate array (FPGA), or a programmable logic array (PLA), using state information of computer readable program instructions.

Aspects of the present disclosure are described herein with reference to flowcharts and/or block diagrams of methods, apparatuses (systems), and computer program products according to embodiments of the present disclosure. It should be understood that each block of the flowchart and/or block diagram, and combinations of blocks in the flowcharts and/or block diagrams, may be implemented by computer readable program instructions.

These computer-readable program instructions may be provided to a processing unit of a general purpose computer, special purpose computer, or other programmable data processing apparatus to produce a machine, such that the instructions, when executed by a processing unit of a computer or other programmable data processing apparatus, produce means to implement the functions/acts specified in the flowchart and/or block diagram. These computer-readable program instructions may also be stored in a computer-readable storage medium that cause the computer, programmable data processing apparatus, and/or other devices to function in a particular manner, such that the computer-readable medium storing instructions includes an article of manufacture including instructions to implement aspects of the functions/acts specified in the flowchart and/or block diagram (s).

The computer-readable program instructions may also be loaded onto a computer, other programmable data processing apparatus, or other apparatus, such that a series of operational steps are performed on a computer, other programmable data processing apparatus, or other apparatus to produce a computer-implemented process such that the instructions executed on a computer, other programmable data processing apparatus, or other apparatus implement the functions/acts specified in the flowchart and/or block diagram block or blocks.

The flowchart and block diagrams in the figures show architecture, functionality, and operation of possible implementations of systems, methods, and computer program products according to various embodiments of the present disclosure. In this regard, each block in the flowchart or block diagram may represent a module, program segment, or portion of an instruction that includes one or more executable instructions for implementing the specified logical function. In some alternative implementations, the functions noted in the blocks may also occur in a different order than noted in the figures. For example, two consecutive blocks may actually be performed substantially in parallel, which may sometimes be performed in the reverse order, depending on the functionality involved. It is also noted that each block in the block diagrams and/or flowchart, as well as combinations of blocks in the block diagrams and/or flowchart, may be implemented with a dedicated hardware-based system that performs the specified functions or actions, or may be implemented in a combination of dedicated hardware and computer instructions.

Various implementations of the present disclosure have been described above, which are illustrative, not exhaustive, and are not limited to the implementations disclosed. Many modifications and variations will be apparent to those of ordinary skill in the art without departing from the scope of the various implementations illustrated. The selection of the terms used herein is intended to best explain the principles of the implementations, practical applications, or improvements to techniques in the marketplace, or to enable others of ordinary skill in the art to understand the various implementations disclosed herein.

## Claims

1. A method for reduced-voltage starting of a motor, the method comprising:
determining (510) a line voltage between a first phase and a second phase in a line in response to obtaining a starting instruction indicating starting of the motor;
determining (520) a zero-crossing point of the line voltage;
starting (530) a first timing in response to reaching the zero-crossing point of the line voltage;
closing (540) a first switch of the first phase and a second switch of the second phase in response to the first timing satisfying a first predetermined duration, the first predetermined duration being determined based on at least the zero-crossing point of the line voltage and closing angle information of the motor;
starting (550) a second timing in response to the first switch and the second switch being closed; and
closing (560) a third switch of a third phase relative to the first phase and the second phase in the line in response to the second timing satisfying a second predetermined duration.

2. The method of claim 1, comprising:
disconnecting three-phase power supply of the line in response to obtaining an abnormal signal indicating an abnormality of the line; and
initializing at least one of the first timing or the second timing.

3. The method of claim 1 or claim 2, comprising:
obtaining voltage information across the first switch, the second switch and the third switch respectively in response to the third switch being closed; and
disconnecting the three-phase power supply of the line in response to the voltage information across the first switch, the second switch, and the third switch exceeding a predetermined threshold.

4. The method of claim 2 or claim 3, comprising:
issuing early warning information in response to the three-phase power supply of the line being disconnected.

5. The method of any of claims 1 to 4, comprising:
determining the first predetermined duration, comprising:
obtaining the closing angle information of the motor;
determining a closing time associated with the closing angle information based on the closing angle information and a power supply frequency; and
determining the first predetermined duration based on the closing time and the zero-crossing point of the line voltage.

6. The method of claim 5, wherein obtaining the closing angle information of the motor comprises:
obtaining a power factor of the motor; and
determining the closing angle information of the motor based on the power factor of the motor.

7. The method of any of claims 1 to 6, wherein the second predetermined duration is determined based on a characteristic parameter of the motor.

8. An apparatus (200) for reduced-voltage starting of a motor, the apparatus (200) comprising:
a task module (210) configured to:
obtain a starting instruction indicating starting of the motor;
a data processing module (220) configured to:
determine a line voltage between a first phase and a second phase in a line based on the starting instruction; and
determine a zero-crossing point of the line voltage; and
a control module (230) configured to:
start a first timing at the zero-crossing point of the line voltage;
close a first switch of the first phase and a second switch of the second phase in response to the first timing satisfying a first predetermined duration, the first predetermined duration being determined based on the zero-crossing point of the line voltage and closing angle information of the motor;
start a second timing in response to the first switch and the second switch being closed; and
close a third switch of a third phase relative to the first phase and the second phase in the line in response to the second timing satisfying a second predetermined duration.

9. The apparatus (200) of claim 8, wherein the task module (210) is configured to at least one of:
disconnect three-phase power supply of the line in response to obtaining an abnormal signal indicating an abnormality of the line; and
initialize at least one of the first timing or the second timing;
or:
obtain voltage information across the first switch, the second switch and the third switch respectively in response to the third switch being closed; and
disconnect three-phase power supply of the line in response to the voltage information across the first switch, the second switch, and the third switch respectively exceeding a predetermined threshold.

10. The apparatus (200) of claim 9, wherein the task module (210) is configured to:
issue early warning information in response to the three-phase power supply of the line being disconnected.

11. The apparatus (200) of any of claims 8 to 10, wherein the data processing module (220) is configured to:
determine a first predetermined duration, comprising:
obtaining closing angle information of the motor;
determining a closing time associated with the closing angle information based on the closing angle information and a power supply frequency; and
determining a first predetermined duration based on the closing time and the zero-crossing point of the line voltage.

12. The apparatus (200) of claim 11, wherein obtaining the closing angle information of the motor comprises:
obtaining a power factor of the motor; and
determining the closing angle information of the motor based on the power factor of the motor.

13. The apparatus (200) of any of claims 8 to 12, wherein the second predetermined duration is determined based on a characteristic parameter of the motor.

14. The apparatus (200) of any of claims 8 to 13, wherein a latency of the data processing module is lower than a latency of the task module; and
a latency of the control module is lower than the latency of the data processing module.

15. A computer program comprising computer-executable instructions, wherein the computer-executable instructions, when executed by a processor, implement the method of any of claims 1 to 7.
